(19) Europäisches Patentamt
European Patent Office
Office européen des brevets

(11) **EP 4 568 115 A1**

(12) **EUROPEAN PATENT APPLICATION**

(43) Date of publication:
**11.06.2025 Bulletin 2025/24**

(21) Application number: **24217394.6**

(22) Date of filing: **04.12.2024**

(51) International Patent Classification (IPC):
*H03M 1/10* (2006.01)    *H03M 1/74* (2006.01)

(52) Cooperative Patent Classification (CPC):
**H03M 1/1033; H03M 1/74**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **04.12.2023 US 202318527444**

(71) Applicant: **Intel Corporation
Santa Clara, CA 95054 (US)**

(72) Inventors:
• **GRUBER, Daniel
9433 St. Andrä (AT)**
• **KALCHER, Michael
9500 Villach (AT)**
• **MADOGLIO, Paolo
Beaverton, 97003 (US)**
• **THALLER, Edwin
9583 Faak am See (AT)**

(74) Representative: **2SPL Patentanwälte PartG mbB
Landaubogen 3
81373 München (DE)**

(54) **METHOD AND APPARATUS FOR SKEW ERROR MEASUREMENT IN A DIGITAL-TO-ANALOG CONVERTER USING A TIME-TO-DIGITAL CONVERTER**

(57)    Method and apparatus for skew error measurement and correction in a digital-to-analog converter (DAC) using a time-to-digital converter (TDC). A DAC includes a main DAC and a TDC. The main DAC includes a plurality of DAC cells. The main DAC is configured to generate an analog output signal based on digital input data. The TDC is coupled to an output of the main DAC and configured to measure a timing error of the main DAC. The timing error may be measured on a DAC cell basis or a subset of DAC cells basis.

FIG. 6B

## Description

## Background

In a digital-to-analog converter (DAC) comprising a plurality of DAC cells, several different performance limitations are present. One limiting factor of DAC performance in terms of linearity and noise is cell matching. While amplitude errors are commonly being corrected by calibration of individual DAC cells, timing skew errors of DAC cells are usually not corrected. However, with higher sampling and signal frequencies, timing skew errors can be a major limitation in DAC performance.

Cell matching of DACs in terms of cell weight or amplitude error is calibrated (static or dynamic calibrations). In current-steering DACs, this is often done with a small static correction DAC in the DAC cells or a split current source with a fixed and trimmed part. Amplitude errors in capacitive DACs cannot be corrected in an analog fashion and require digital correction. However, extra hardware is needed for trimming cell amplitudes.

Random skew errors may be minimized down to a tolerable level by scaling up circuitry and designing for matching. However, sizing hardware for sufficiently low skew errors requires to increase device sizes to improve matching. This impacts area and power dissipation due to bigger devices than needed for functionality.

## Brief description of the Figures

Some examples of apparatuses and/or methods will be described in the following by way of example only, and with reference to the accompanying figures, in which:

FIG. 1 shows an example of amplitude mismatch and timing skew of one DAC cell;
FIG. 2 shows the spectrum of DAC output for a 6 GHz two-tone test signal with and without skew errors;
FIG. 3A shows an example of skew of a DAC cell;
FIG. 3B shows an error pulse incurred due to the timing skew;
FIG. 3C shows example correction pulses applied by the correction DAC for cancelling/reducing the skew errors shown in FIG. 3B;
FIG. 4 shows a DAC including a TDC for timing skew measurement of a main DAC in accordance with one example;
FIG. 5 shows an example multi-bit DAC with a TDC for timing skew measurement;
FIG. 6A shows one example implementation of a DAC for correcting the skew errors;
FIG. 6B shows another example that the skew correction is applied to the digital input stream of the DAC;
FIG. 6C shows another example that the skew error of a cell is trimmed based on the measured skew error;
FIG. 7 shows an example segmented DAC with a TDC for measuring a timing skew;
FIG. 8 shows a time-interleaved DAC with a TDC in accordance with one example;
FIG. 9 shows an example DAC with a TDC wherein a reference signal is provided to the TDC for timing skew measurement;
FIG. 10 shows an example DAC with a TDC and a reference cell;
FIG. 11 shows an example DAC with a TDC and controllable delay and/or gain units;
FIG. 12 is a flow diagram of an example process of measuring timing skew and correcting the timing errors of a DAC;
FIG. 13 illustrates a user device in which the examples disclosed herein may be implemented; and
FIG. 14 illustrates a base station or infrastructure equipment radio head in which the examples disclosed herein may be implemented.

## Detailed Description

Various examples will now be described more fully with reference to the accompanying drawings in which some examples are illustrated. In the figures, the thicknesses of lines, layers and/or regions may be exaggerated for clarity.

Accordingly, while further examples are capable of various modifications and alternative forms, some particular examples thereof are shown in the figures and will subsequently be described in detail. However, this detailed description does not limit further examples to the particular forms described. Further examples may cover all modifications, equivalents, and alternatives falling within the scope of the disclosure. Like numbers refer to like or similar elements throughout the description of the figures, which may be implemented identically or in modified form when compared to one another while providing for the same or a similar functionality.

It will be understood that when an element is referred to as being "connected" or "coupled" to another element, the elements may be directly connected or coupled or via one or more intervening elements. If two elements A and B are combined using an "or", this is to be understood to disclose all possible combinations, i.e., only A, only B as well as A and B. An alternative wording for the same combinations is "at least one of A and B". The same applies for combinations of more than 2 elements.

The terminology used herein for the purpose of describing particular examples is not intended to be limiting for further examples. Whenever a singular form such as "a," "an" and "the" is used and using only a single element is neither explicitly or implicitly defined as being mandatory, further examples may also use plural elements to implement the same functionality. Likewise, when a functionality is subsequently described as being implemented using multiple elements, further examples may implement the same functionality using a single element or processing entity. It will be further understood that the terms "comprises," "comprising," "includes" and/or "including," when used, specify the presence of the stated features, integers, steps, operations, processes, acts, elements and/or components, but do not preclude the presence or addition of one or more other features, integers, steps, operations, processes, acts, elements, components and/or any group thereof.

Unless otherwise defined, all terms (including technical and scientific terms) are used herein in their ordinary meaning of the art to which the examples belong.

In a DAC that is built up of a plurality of cells (DAC cells), the individual DAC cells will show random variations, which is called mismatch/skew. Mismatch/skew can have deterministic cause or originate from random variations in devices from processing, etc. Different device types can show different mismatch/skew behavior. As a common rule, for reducing random variations devices have to be made bigger to improve matching between them.

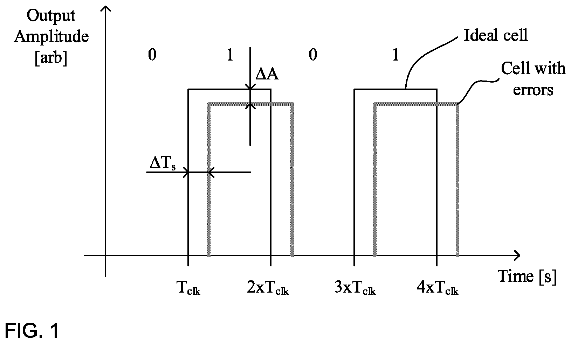

Cells within one DAC show variations of amplitude and timing behavior, called amplitude mismatch and timing skew. FIG. 1 shows an example of amplitude mismatch and timing skew of one DAC cell. The amplitude mismatch is the difference of the DAC cell amplitude to the ideal cell, depicted as $\Delta A$. The timing skew is the difference of the ideal time instant when the DAC cell should switch to when it really switches, depicted at $\Delta T_s$.

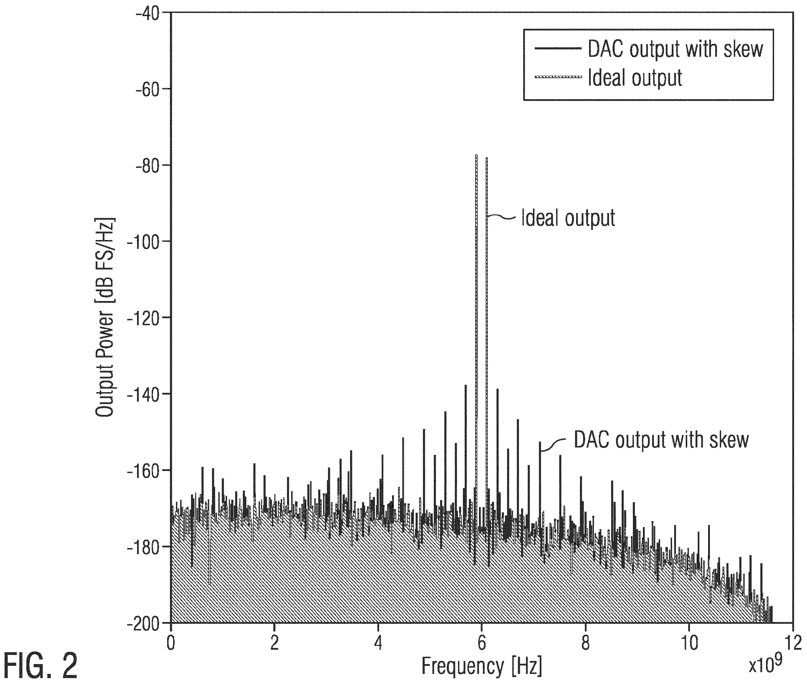

The errors (i.e., the amplitude mismatch and timing skew) will ultimately limit the DAC performance. This can be seen in FIG. 2. FIG. 2 shows the spectrum of DAC output for a 6 GHz two-tone test signal with and without skew errors. FIG. 2 shows the output spectrum of a 13-bit segmented DAC with a unary coded most-significant bit (MSB) segment of 5 bits. The unary coded segment has a random skew error with a standard deviation of 200 fs. In FIG. 2, the introduced errors are clearly visible as tones in the entire spectrum, limiting spurious free dynamic range (SFDR) and signal-to-noise and distortion ratio (SNDR) performance. A skew error of only 200 fs standard deviation is very small and requires spending significant efforts in design. Hence there is a desire to correct for these errors.

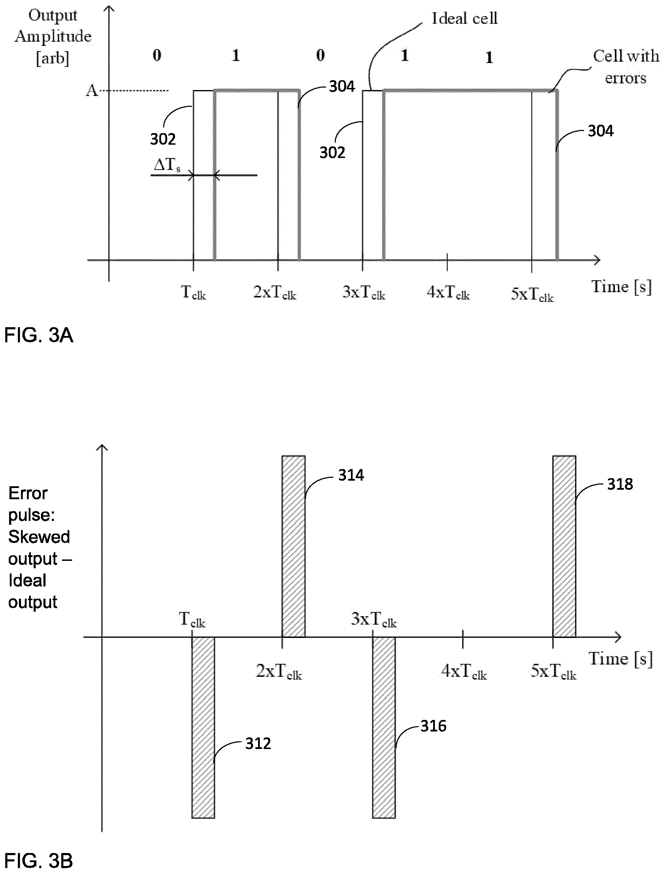

The skew error modelling in digital domain is explained hereafter. A skew is a time shift of a DAC cell output. A DAC cell may not switch at the ideal time instant but at a time offset of $\Delta Ts$. The time offset $\Delta Ts$ can be positive or negative. The modelling of the skew error may be done in the following way. FIG. 3A shows an example of skew of a DAC cell and FIG. 3B shows an error pulse incurred due to the timing skew. In the example shown in FIG. 3A, a single DAC cell switches with a 01011 pattern. In this example, the cell is switching delayed by $\Delta Ts$ relative to an ideal cell, i.e., the actual cell output 304 is delayed by $\Delta Ts$ relative to the ideal cell output 302. Whenever the cell is transitioning from state 0 (off) to state 1 (on), or vice versa, an error is introduced that has the energy of cell amplitude A times the skew $\Delta Ts$: $A \cdot \Delta T_s$. This error pulse (i.e., the skewed cell output minus the ideal cell output) is either positive or negative or zero depending on the transition of the cell. Since the cell is switching too late in this example shown in FIG. 3A, the error pulses 312 and 316 are negative when the cell is switching from 0 to 1 (the skewed cell output minus the ideal output < 0) and the error pulses 314 and 318 are positive when the cell is switching from 1 to 0 (the skewed cell output minus the ideal output > 0). When the cell is not switching at all no error is introduced. For example, the skew error can be modelled as the derivative of the cell input $x_n$ times the cell amplitude A times the skew $\Delta T_s$ as follows:

$$E_{cell}(n) = \left( x_n(n) - x_n(n-1) \right) A \Delta T_s. \qquad \text{Equation (1)}$$

This is a representation of the error energy of the cell due to skew suitable for digital modelling. In examples, a correction pulse may be generated by a correction DAC to cancel or reduce the error pulse, which will be explained below.

As shown in FIG. 3A, a skew (timing error) only shows up when a cell is transitioning from one state to another, e.g., switching ON/OFF or switching polarity. The skew can be the same for the rising edge and falling edge of the transition or be different.

In some examples, a correction signal may be applied for correction of a skew error, at the time point when the error is occurring. Assuming that the correction is performed by a correction DAC that has the same sampling clock frequency as the main DAC, a very short pulse of the skew error may not be accurately represented. Yet, applying the correct error energy $E_{cell}(n)$ at the clock time instant $T_{clk}(n) - T_{clk}/2$ is a good representation of the error as the center of gravity of the error pulse and correction pulse are nearly identical. In illustrative, nonlimiting, examples, the correction pulse to cancel the error pulse may be spread out over an entire clock period $T_{clk}$, yielding a correction pulse amplitude as follows:

$$A_{corr}(n) = E_{cell}(n) / T_{clk}(n) = \frac{(x_n(n) - x_n(n-1)) A \Delta T_s}{T_{clk}(n)}. \qquad \text{Equation (2)}$$

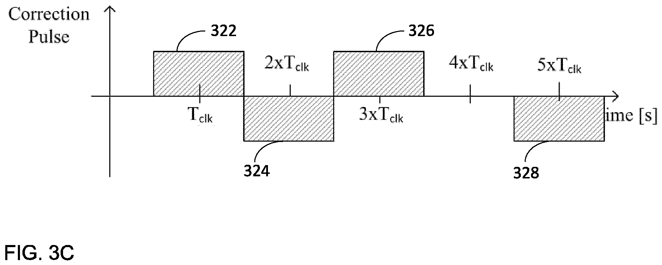

FIG. 3C shows example correction pulses 322, 324, 326, 328 applied by the correction DAC for cancelling/reducing the skew errors (error pulses 312, 314, 314, 318) shown in FIG. 3B. In this example, each correction pulse 322, 324, 326, 328 is spread out over an entire clock period $T_{clk}$. Since the random skew is not varying, or only very little varying, over time, the term $\dfrac{A\Delta T_S}{T_{clk}}$ in Equation (2) can be regarded as constant, which greatly simplifies the calculations.

In examples, as shown in FIG. 3C, each correction pulse 322, 324, 326, 328 may be shifted by half a clock period. Alternatively, the correction pulses 322, 324, 326, 328 may not be shifted in time. If the time at which the correction (a correction pulse) is applied is shifted by half a clock, the correction DAC should be out-phased from the main DAC by half a clock cycle. This may be done by either delaying the main DAC by half a clock or skipping ½ clock delay for the correction DAC, e.g., by omitting one latch inside a flipflop. This may be performed without incurring additional overhead since the DAC data path up to the final driver of the DAC cells includes a number of latches, typically 3-5 in a high-speed DAC, such that one latching stage can be omitted for the skew error correction DAC without disrupting the homogeneity of the array. The clock in a high-speed DAC is usually a (pseudo-) differential clock. In such case, a local clock inversion may be done only by a wire-crossing. Alternatively, the skew correction may be applied to the digital input stream of the DAC, or the skew error of a cell may be trimmed based on the measured skew error for each cell, which will be explained in detail below.

Hereafter, examples are disclosed for (cell-wise) skew error measurement in a DAC using a time-to-digital converter (TDC). In examples disclosed herein, the skew errors of DAC cells are measured on a per cell basis, per subset of cells basis, per segment basis, or per sub-DAC basis using a TDC. The resulting skew error estimate is used to correct the signal impairments due to skew errors by either using the values to calibrate DAC cells, segments, or sub-DAC(s), or performing digital correction of the skew errors, or performing digital calculation of the skew errors and correcting the DAC output signal using dedicated hardware, etc.

This scheme allows to characterize skew errors within a DAC in order to correct for those skew errors, allowing to relax design requirements in terms of timing skew matching. This can result in reduced area and significantly reduced power consumption. The required correction DAC is a very small area/power overhead as the errors to be corrected are very small to begin with.

Measuring timing errors (i.e., skew errors) of DAC cells in the sub-100 fs scale is very challenging. The example schemes disclosed herein use a TDC to measure the timing of a DAC cell(s) vs. a reference for one cell at a time, a set of cells at a time, a segment within a segmented DAC at a time, or one sub-DAC of an interleaved DAC at a time.

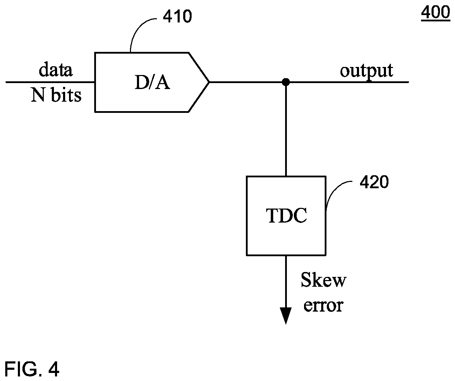

FIG. 4 shows a DAC 400 including a TDC 420 for timing skew (timing error) measurement of a main DAC 410 in accordance with one example. The DAC 400 includes a main DAC 410 and a TDC 420. The main DAC 410 includes a plurality of DAC cells and is configured to generate an analog output signal based on digital input data (N bits). The main DAC 410 may be any type of conventional DAC.

The TDC 420 is coupled to an output of the main DAC 410 and measures a timing skew (timing error) of the main DAC 410. A TDC is a device used to determine the time interval between two events (e.g., an interval between two signal pulses (a start pulse and a stop pulse). Any conventional TDC may be used to measure the timing skew (timing error) of the cells of the main DAC 410. The TDC 420 may measure the output transitions of the main DAC 410 relative to a reference signal and provide a digital value proportional to the time difference between the output transition of the main DAC 410 and the reference signal. The measurement of individual DAC cells or a subset of DAC cells may be relative to the reference signal. The measurements of the individual DAC cells or a subset of DAC cells relative to each other are a representation of the timing skew or skew errors of the cells.

The main DAC 410 may include a plurality of DAC cells, and the timing error may be measured for each DAC cell or for a subset of the DAC cells. The main DAC 410 may be a segmented DAC including two or more segments, and the timing error may also be measured for each segment of the segmented DAC. The main DAC 410 may be a time-interleaved DAC including a plurality of sub-DACs and the timing error may also be measured for each sub-DAC.

In some examples, a reference signal may be provided to the TDC 420 and the TDC 420 may measure the timing error based on the reference signal, i.e., the TDC 420 may measure the timing error between the output of the main DAC 410 and the reference signal. For example, the reference signal for the TDC 420 may be derived from a clock signal that is fed to the main DAC 410. Alternatively, the same clock signal may be fed to the main DAC 410 and the TDC 420, and the TDC 420 may measure the timing interval between the output of the main DAC 410 and the reference signal.

In some examples, the reference signal may be generated by a reference DAC cell. The TDC 420 may measure the timing interval between the output of the main DAC 410 and the output of the reference DAC cell. The reference DAC cell may be one of the plurality of DAC cells of the main DAC 410.

In some examples, the DAC 400 may include an adjustable delay unit configured to delay either the reference signal or the analog output signal from the main DAC 410. The TDC 420 has a certain time range that can be measured. The TDC 420 can measure the time interval between two events within the time range. The adjustable delay may delay either the analog output signal of the main DAC 410 or the reference signal to ensure that the analog output signal from the main DAC 410 is sampled by the TDC 420 within the TDC time range (i.e., the adjustable delay may be adjusted until the output of the main DAC 410 and the reference signal reach the TDC 420 within the TDC time range).

The DAC 400 may also include a (adjustable) gain unit configured to adjust a signal amplitude of the reference signal and/or the analog output signal from the main DAC 410. For example, the TDC 420 may be connected to the reference signal and the output of the main DAC 410 via an amplifier with a gain control. The output of the main DAC 410 and/or the reference signal may be amplified by the variable gain unit to generate signal edges that can be properly sampled by the TDC 420.

In some examples, the DAC 400 may include a post processing unit to process the timing error measurements measured by the TDC 420. For example, the post-processing unit may average a plurality of consecutive TDC measurements. The post-processing may reduce the noise impact of the TDC, jitter of the reference signal (e.g., clock), and/or noise of the transition of the measured cells, etc.

In some examples, the DAC 400 may further include a cell skew error determination circuit, a correction DAC, and a combiner for correcting the timing error. The cell skew error determination circuit is configured to determine the cell skew errors for the DAC cells based on the skews of the DAC cells measured by the TDC 420 or by the post-processing unit. The correction DAC is configured to generate a correction signal based on the skew error of the main DAC. The combiner may combine the correction signal with the analog output signal generated by the main DAC 410.

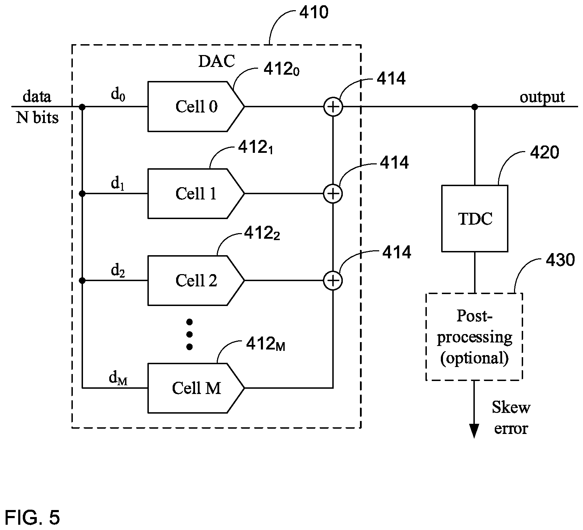

If a DAC is not a single-bit DAC, the DAC is constructed with an array of DAC cells that can be encoded in different ways. FIG. 5 shows an example multi-bit DAC (a main DAC 410) with a TDC 420 for timing skew measurement. The main DAC 410 includes a plurality of DAC cells $412_0$-$412_M$ (Cell 0 to Cell M). Each cell $412_0$-$412_M$ generates an output that contributes to the output of the main DAC 410 based on the input bit to each cell $412_0$-$412_M$. The input bit may be a binary-coded bit or a thermometer-coded bit, or the like. Cell 0 $412_0$ generates an output based on input bit d0, Cell 1 $412_1$ generates an output based on input bit d1, and so on. The outputs of the DAC cells $412_0$-$412_M$ are combined by one or more adders/combiners 414 to generate a DAC output. A measurement circuit (i.e., a TDC 420) is attached to the output of the main DAC 410 and measures timing skew of the main DAC 410 on a cell basis, a subset of cells basis, a segment basis, or a sub-DAC basis. In one example, the DAC cells $412_0$-$412_M$ may be all binary-weighted as needed for binary encoding. Alternatively, the DAC cells $412_0$-$412_M$ may be all unary-weighted as needed for a thermometer encoding of the input data. Alternatively, a combination of binary-weighting and unary-weighting may be used.

The TDC 420 measures the output transitions of the main DAC 410 relative to a reference signal and provides a digital value proportional to the time difference between the transitions of the output signal of the main DAC 410 and the reference signal. The measurement of individual DAC cells or a subset of DAC cells are all relative to the reference signal. The measurements of the individual DAC cells or a subset of DAC cells relative to each other can be a representation of the timing skew or skew errors of the cells.

A post processing unit 430 may process the timing measurements measured by the TDC 420. For example, the post-processing unit 430 may average a plurality of consecutive TDC measurements to generate a skew error for a cell, a subset of cells, a DAC segment, or a sub-DAC.

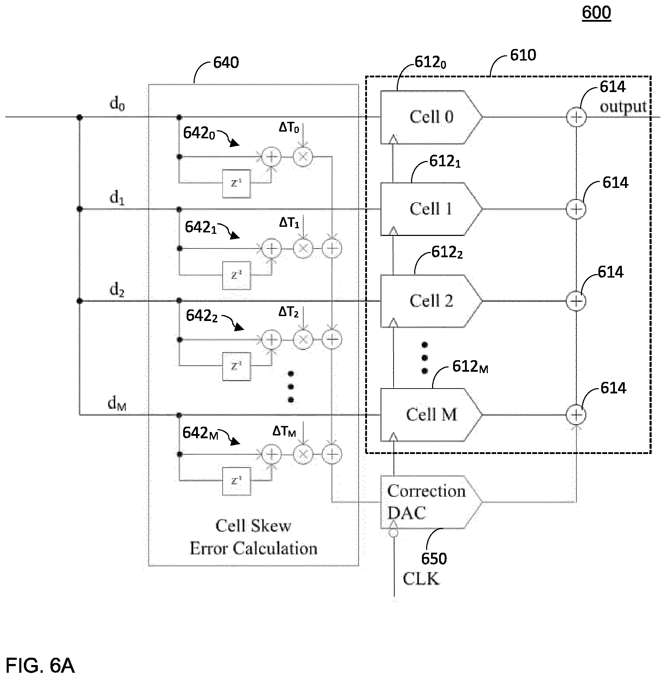

FIG. 6A shows one example implementation of a DAC for correcting the skew errors. The DAC 600 includes a main DAC 610, a cell skew error determination circuit 640, and a correction DAC 650. The main DAC 610 includes a plurality of cells (Cell 0 to Cell M) $612_0$-$612_M$. Each cell $612_0$-$612_M$ generates an output that contributes to the output of the main DAC 610 based on the input bit to each cell $612_0$-$612_M$. The input bit may be a binary-coded bit or a thermometer-coded bit, or the like. Cell 0 $612_0$ generates an output based on input bit d0, Cell 1 $612_1$ generates an output based on input bit d1, and so on. The outputs of the plurality of cells $612_0$-$612_M$ are combined by a combiner(s) 614 to generate the output of the main DAC 610.

The cell skew error determination circuit 640 determines the cell skew errors. The skew errors may be calculated for the cells $612_0$-$612_M$ and then summed and fed to the correction DAC 650. The cell skew error determination circuit 640 may include a digital filter $642_0$-$642_M$ for each cell $612_0$-$612_M$ of the main DAC 610. The digital input bit to each cell $612_0$-$612_M$ of the main DAC 610 is input to the corresponding digital filter $642_0$-$642_M$. Each digital filter $642_0$-$642_M$ processes the input bit for the corresponding cell $612_0$-$612_M$ to generate a skew error that the corresponding cell $612_0$-$612_M$ introduces to the DAC output. In this example, each digital filter $642_0$-$642_M$ processes the input bit according to Equation (1) above. The previous input data is subtracted from the current input data and then multiplied with the $\Delta T_s$ value for each DAC cell $612_0$-$612_M$ to generate a skew error that the corresponding cell $612_0$-$612_M$ introduces to the DAC output. It should be noted that the model for the skew error determination in FIG. 6A is merely one example and the skew error may be modeled differently. The skew error may be calculated using a finite impulse response (FIR) filter or an infinite impulse response (IIR) filter, or any other linear or non-linear filters. More complex digital filtering may be used to replicate the skew errors more precisely than the simple derivative function used in Equation (1).

The timing skew $\Delta T_0$-$\Delta T_M$ of each cell $612_0$-$612_M$ is determined by the TDC 420 (not shown in FIG. 6A) coupled to the output of the DAC 610 or optionally by the post-processing unit 430 (not shown in FIG. 6A) as explained above. The skew errors that the cells $612_0$-$612_M$ introduce are summed over the entire cells $612_0$-$612_M$ and the sum is sent to the correction DAC 650. The correction DAC 650 generates a correction signal based on the summed skew errors of the cells $612_0$-$612_M$. The output of the correction DAC 650 is subtracted from the output of the main DAC 610. The output of the correction DAC 650 may be applied over the entire clock cycle. For correction of the skew error, the correction DAC 650 may be out-of-phase with the main DAC 610 (e.g., a half clock cycle). For example, the correction DAC 650 may use the inverted clock phase with respect to the main DAC 610, out-phasing the correction pulses by half a clock. Alternatively, the correction DAC 650 may be in-phase with the main DAC 610.

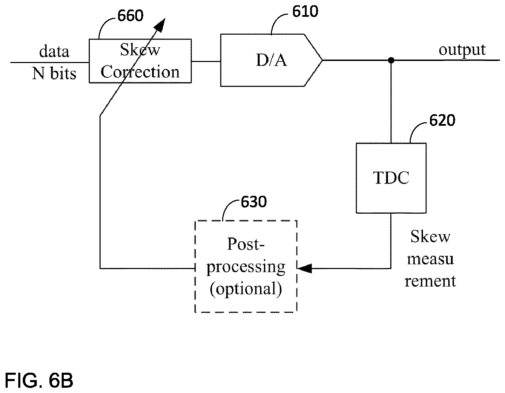

FIG. 6B shows another example that the skew correction is applied to the digital input stream of the DAC. The TDC 620 is coupled to the output of the main DAC 610 and measures the timing skew of the main DAC 610 as explained above. The TDC output may be optionally post-processed by the post-processing unit 630. A skew correction may be applied to the digital input stream of the DAC 610 by the skew correction unit 660. In this example, instead of adding the correction in the analog domain as in FIG. 6A, the cell skew error is calculated as in FIG. 6A, and the correction for the cell skew error is added to the input digital data by the skew correction unit 660.

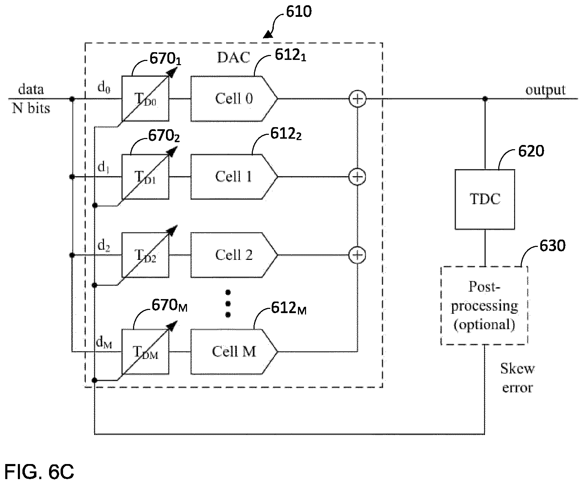

FIG. 6C shows another example that the skew error of a cell is trimmed based on the measured skew error. The TDC 620 is coupled to the output of the main DAC 610 and measures the timing skew of the main DAC 610 as explained above. The TDC output may be optionally further processed by the post-processing unit 630. In this example, the skew error is measured for each cell $612_1$-$612_M$ and the timing of each cell $612_1$-$612_M$ is trimmed (adjusted) by the correction units $670_1$-$670_M$ (e.g., adjustable delay units) based on the measured skew error for each cell $612_1$-$612_M$, respectively.

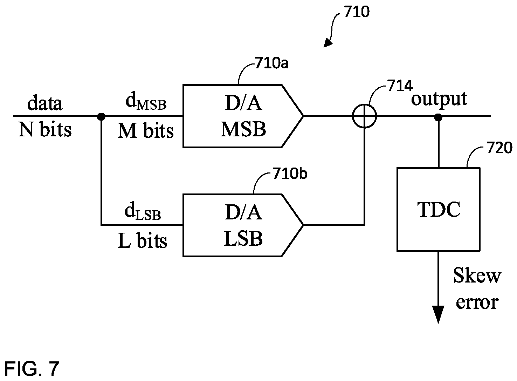

The main DAC may be a segmented DAC and the timing skew may be measured/determined for each segment. FIG. 7 shows an example segmented DAC with a TDC for measuring a timing skew. In this example, the DAC 710 includes two segments: the most-significant bit (MSB) segment 710a and the least-significant bit (LSB) segment 710b. The two-segment DAC is merely an example, and the DAC 710 may include more than two segments. M bits of the N input data bits are sent to the MSB segment 710a and the remaining L bits of the N input data bits are sent to the LSB segment 710b. Each segment 710a, 710b is encoded in accordance with a certain encoding scheme. For example, the MSB segment 710a may be thermometer-coded and the LSB segment 710b may be binary-coded. Alternatively, any other weighting/coding scheme may be used. The outputs of the MSB segment 710a and the LSB segment 710b contribute to the output of the DAC 710. The outputs of the MSB segment 710a and the output of the LSB segment 710b are combined by an adder 714 and a TDC 720 is connected to the output of the DAC 710. The TDC 720 may be used to measure the timing skew of one cell at a time, a subset of cells at a time, or a DAC segment at a time. In this example, the TDC 720 may measure the timing skew of a cell of the MSB segment 710a or LSB segment 710b at a time, or a subset of cells of the MSB segment 710a or LSB segment 710b at a time, or the MSB segment 710a or the LSB segment 710b at a time.

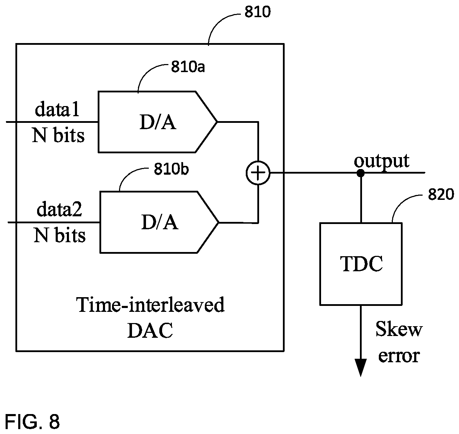

FIG. 8 shows a time-interleaved DAC with a TDC in accordance with one example. Time-interleaving of DACs is a way to increase the overall system sampling rate by using several DACs (sub-DACs) in parallel. The time-interleaved DAC 810 includes a plurality of sub-DACs 810a, 810b (M sub-DACs) coupled in parallel. The example shown in FIG. 8 shows only two sub-DACs 810a, 810b, but the time-interleaved DAC may include more than two sub-DACs. When one sub-DAC 810a or 810b is creating an analog output, the other sub-DAC 810b or 810a prepares for the data for the next cycle. The TDC 820 is coupled to the output of the time-interleaved DAC 810 and measures timing skew of the DAC 810. The sub-DACs 810a, 810b of the time-interleaved DAC 810 may be measured individually to determine the cell skew within each sub-DAC 810a, 810b. For example, the TDC 820 may measure the timing skew of a cell of one of the sub-DACs 810a, 810b at a time, or a subset of cells of one of the sub-DACs 810a, 810b at a time, or the sub-DAC 810a or the sub-DAC 810b at a time. The time-interleaving error of the sub-DACs 810a, 810b relative to each other may also be measured.

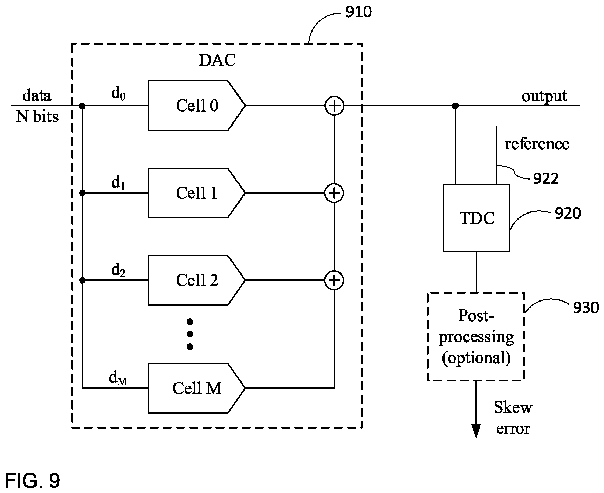

FIG. 9 shows an example DAC with a TDC wherein a reference signal is provided to the TDC for timing skew measurement. The TDC 920 is coupled to the output of the main DAC 910 and the reference signal 922 and measures the timing error of the main DAC 910 based on the reference signal 922. The reference signal 922 for the TDC 920 against which the timing error is measured may be generated in different ways. In some examples, the reference signal 922 may be a clock signal. For example, the sampling clock of the main DAC 910 (or a clock signal derived from the sampling clock of the main DAC 910) may be fed to the TDC 920 as a reference signal 922. The TDC 920 may provide an output at a subset of the clock edges of the reference clock signal fed to the TDC 920, taking a measurement only every M clock cycles.

The optional post-processing may be performed by the post-processing block 930 to enhance the resolution of the measurements. For example, the post-processing block 930 may perform averaging of the TDC measurement results to reduce the noise impact of the TDC, jitter of the reference signal (e.g., clock), and/or noise of the transition of the measured cells, etc.

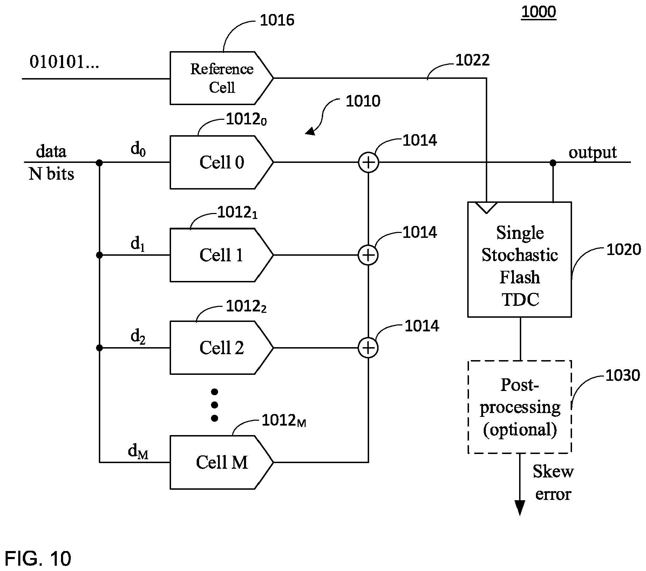

FIG. 10 shows an example DAC with a TDC and a reference cell. The DAC 1000 includes a main DAC 1010, a TDC 1020, and a reference cell 1016. The main DAC 1010 includes a plurality of cells (Cell 0 to Cell M) $1012_0$-$1012_M$. Each cell $1012_0$-$1012_M$ generates an output that contributes to the output of the main DAC 1010 based on the input bit to each cell $1012_0$-$1012_M$. The input bit may be a binary-coded bit or a thermometer-coded bit, or the like. Cell 0 $1012_0$ generates an output based on input bit d0, Cell 1 $1012_1$ generates an output based on input bit d1, and so on. The outputs of the plurality of cells $1012_0$-$1012_M$ are combined by a combiner(s) 1014 to generate the analog output of the main DAC 1010.

A measurement circuit (i.e., a TDC 1020) is attached to the output of the main DAC 1010 and measures timing skew of the main DAC 1010 based on the reference signal 1022 on a cell or subset of cells basis. The TDC 1020 measures the output transitions of the main DAC 1010 relative to the reference signal 1022 and provides a digital value proportional to the time difference between the transitions of the output signal of the main DAC 1010 and the reference signal 1022. The reference signal 1022 may be an output of a reference DAC cell 1016. The reference DAC cell 1016 may be a separate cell or one of the DAC cells $1012_0$-$1012_M$ of the main DAC 1010.

A post processing unit 1030 may process the timing measurements of the TDC 1020. For example, the prost-processing unit 1030 may average a plurality of consecutive TDC measurements to generate a skew error for a cell or a subset of cells.

The reference for the TDC measurement may be a dedicated reference cell in the array of DAC cells of the main DAC 1010 or in proximity of the array of DAC cells of the main DAC 1010. The reference cell 1016 may be driven by the same sampling clock as the main DAC array or by a sampling clock that is phase synchronized to the main DAC sampling clock. The sampling clock of the reference cell 1016 may be a divided sampling clock of the main DAC 1010. The reference cell 1016 may be fed with an arbitrary data sequence such that a transition in positive or negative direction of the reference signal may trigger a conversion of the TDC 1020 to measure the output of the main DAC 1010.

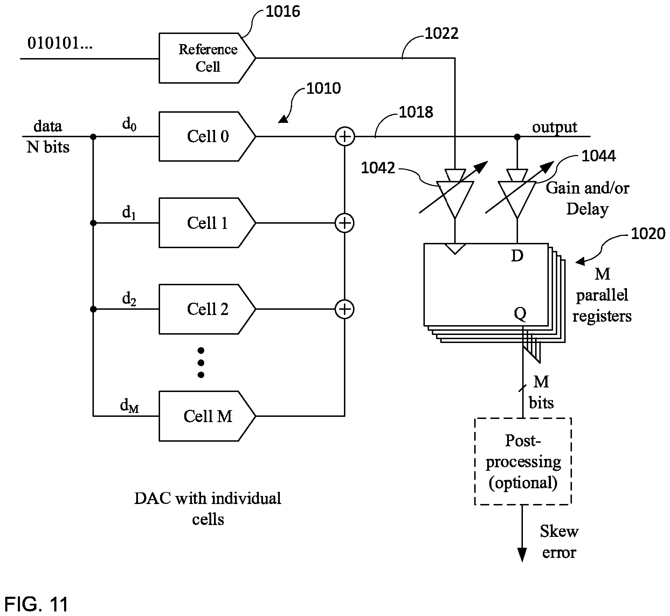

As illustrated in FIG. 10, the TDC 1020 may be as simple as a stochastic flash TDC with a single stage. Since the TDC 1020 (especially stochastic flash TDC) has a limited time range that can be measured, it has to be guaranteed that the sampling clock or reference signal of the TDC 1020 and the analog output signal of the main DAC 1010 are aligned in a way that the edges of the analog output signal of the main DAC 1010 can be measured by the TDC 1020. One example way to guarantee this operation is depicted in FIG. 11.

FIG. 11 shows an example DAC with a TDC and controllable delay and/or gain units. In examples, the reference signal 1022 and/or the DAC output 1018 may be connected to the TDC 1020 (e.g., a stochastic flash TDC) via a controllable delay/gain circuit 1042, 1044. The delay of either the analog output signal 1018 of the main DAC 1010 or the reference signal 1022 may be adjusted until the sampling of the analog output signal 1018 with the TDC 1020 can be guaranteed (i.e., until the reference signal 1022 and the analog output signal 1018 reach the TDC 1020 within the TDC time range). FIG. 11 shows that the delay is applied at the input of the TDC 1020. However, the delay may be applied anywhere along the reference signal path and not necessarily at the TDC input.

In examples, the TDC 1020 may be connected to the reference signal 1022 and the DAC output 1018 via an amplifier with optional gain control (a variable gain amplifier). The variable gain amplifier may adaptively amplify the DAC output 1018 and/or the reference signal 1022. The DAC output signal 1018 and/or the reference signal 1022 may be amplified to generate signal edges that can be sampled properly using the TDC 1020.

DAC cells may be measured on a per-cell basis by feeding an input signal (e.g., an arbitrary signal) one cell at a time. DAC cells may be measured using the TDC outputs only of the time instants when a signal transition at the DAC output occurs. For example, for simpler measurements, a DAC cell may be fed with a periodic waveform such as a 0-1-0-1 sequence or any periodic or non-periodic test sequence, producing a signal transition and edge at (every) clock cycle. The periodic waveform may be chosen in a way that signal transitions occur aligned with the TDC reference signal. In some examples, the input waveform to a DAC cell may be chosen in a way that the TDC can capture only rising DAC output signal transitions, only falling DAC output transitions, or both transitions.

Alternatively, the measurements of the main DAC output may be individually triggered by a calibration, a test controller, firmware, or software. For instance, a calibration program (or state machine) may request a single or multiple measurements, generating the required reference clock transitions. Assuming they are adequately timed to correctly operate the TDC, e.g., by an appropriate delay, the measurement may be fully controlled by (calibration and/or test) software or dedicated controller. Additionally, the controller (hardware, software, or firmware) may also take control of the DAC in order to select the measured DAC cell(s), the switching behavior, etc.

In case that a segmented DAC is used the TDC may measure the skew of DAC segments relative to each other. In this case a measurement may be performed on one cell, multiple cells, or all cells of a segment at a time.

The TDC may be used in a Built-In-Self-Test to measure certain DAC characteristics. For example, the TDC may be used to detect broken cells that show no transition at the DAC output when driven with a test signal. The TDC may also be used to measure a skew integral non-linearity/differential non-linearity (INL/DNL) of a DAC array where the values can be used to determine if the DAC performance can be sufficient.

Further, the TDC may be used to detect timing errors in the DAC by observing if all DAC output node transitions occur at the time instants as intended or if the transitions are sporadically or always delayed compared to the expected value, showing timing violations of one or more DAC cells.

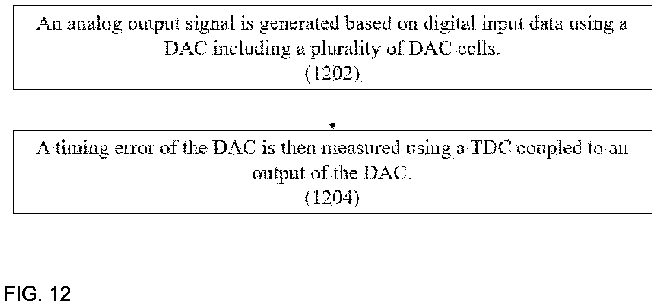

FIG. 12 is a flow diagram of an example process of measuring timing skew and correcting the timing errors of a DAC. An analog output signal is generated based on digital input data using a DAC including a plurality of DAC cells (1202). A timing error of the DAC is measured using a TDC coupled to an output of the DAC (1204). The timing error of the DAC is then corrected. The timing error may be measured for each DAC cell, a set of DAC cells, a segment of the DAC, or a sub-DAC.

A reference signal may be provided to the TDC, and the timing error may be measured based on the reference signal. The reference signal may be same as or derived from a clock signal that is fed to the DAC. The reference signal may be an output of a reference DAC cell. A delay or gain adjustment may be performed either on the reference signal or the analog output signal of the DAC. Post processing may be further performed on the timing error measurements made by the TDC. The timing error may be corrected by generating, using a correction DAC, an analog error signal based on the timing error and combining the analog error signal with the analog output signal generated by the DAC.

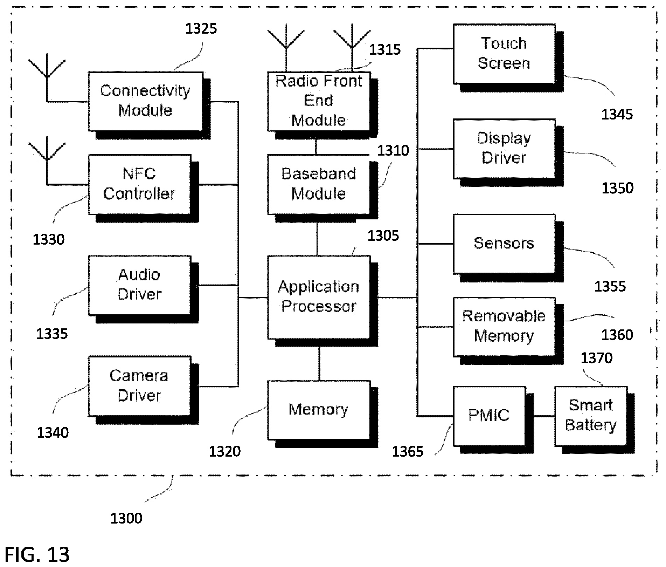

FIG. 13 illustrates a user device 1300 in which the examples disclosed herein may be implemented. For example, the examples disclosed herein may be implemented in the radio front-end module 1315, in the baseband module 1310, etc. The user device 1300 may be a mobile device in some aspects and includes an application processor 1305, baseband processor 1310 (also referred to as a baseband module), radio front end module (RFEM) 1315, memory 1320, connectivity module 1325, near field communication (NFC) controller 1330, audio driver 1335, camera driver 1340, touch screen 1345, display driver 1350, sensors 1355, removable memory 1360, power management integrated circuit (PMIC) 1365 and smart battery 1370.

In some aspects, application processor 1305 may include, for example, one or more CPU cores and one or more of cache memory, low drop-out voltage regulators (LDOs), interrupt controllers, serial interfaces such as serial peripheral interface (SPI), inter-integrated circuit (I2C) or universal programmable serial interface module, real time clock (RTC), timer-counters including interval and watchdog timers, general purpose input-output (IO), memory card controllers such as secure digital / multi-media card (SD/MMC) or similar, universal serial bus (USB) interfaces, mobile industry processor interface (MIPI) interfaces and Joint Test Access Group (JTAG) test access ports.

In some aspects, baseband module 1310 may be implemented, for example, as a solder-down substrate including one or more integrated circuits, a single packaged integrated circuit soldered to a main circuit board, and/or a multi-chip module containing two or more integrated circuits.

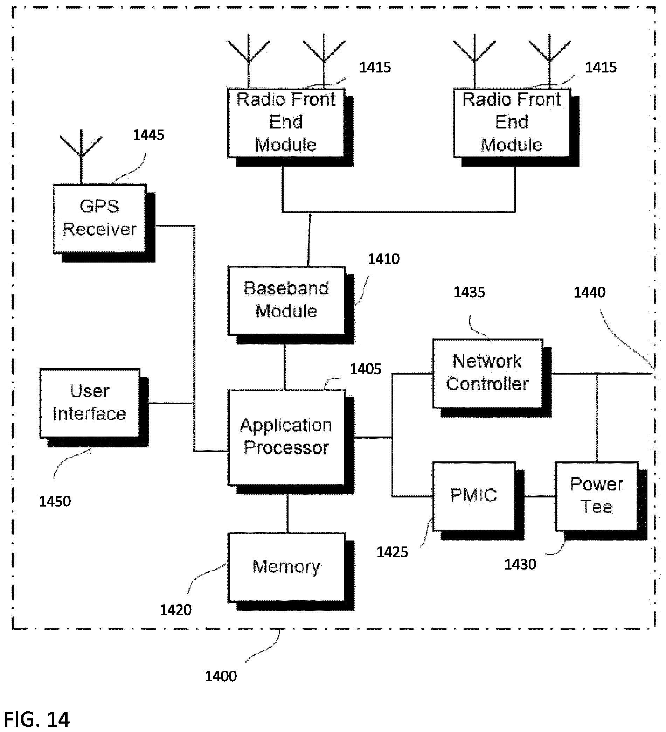

FIG. 14 illustrates a base station or infrastructure equipment radio head 1400 in which the examples disclosed herein may be implemented. For example, the examples disclosed herein may be implemented in the radio front-end module 1415, in the baseband module 1410, etc. The base station radio head 1400 may include one or more of application processor 1405, baseband modules 1410, one or more radio front end modules 1415, memory 1420, power management circuitry 1425, power tee circuitry 1430, network controller 1435, network interface connector 1440, satellite navigation receiver module 1445, and user interface 1450.

In some aspects, application processor 1405 may include one or more CPU cores and one or more of cache memory, low drop-out voltage regulators (LDOs), interrupt controllers, serial interfaces such as SPI, I2C or universal programmable serial interface module, real time clock (RTC), timer-counters including interval and watchdog timers, general purpose IO, memory card controllers such as SD/MMC or similar, USB interfaces, MIPI interfaces and Joint Test Access Group (JTAG) test access ports.

In some aspects, baseband processor 1410 may be implemented, for example, as a solder-down substrate including one or more integrated circuits, a single packaged integrated circuit soldered to a main circuit board or a multi-chip module containing two or more integrated circuits.

In some aspects, memory 1420 may include one or more of volatile memory including dynamic random access memory (DRAM) and/or synchronous dynamic random access memory (SDRAM), and nonvolatile memory (NVM) including high-speed electrically erasable memory (commonly referred to as Flash memory), phase change random access memory (PRAM), magneto resistive random access memory (MRAM) and/or a three-dimensional crosspoint memory. Memory 1420 may be implemented as one or more of solder down packaged integrated circuits, socketed memory modules and plug-in memory cards.

In some aspects, power management integrated circuitry 1425 may include one or more of voltage regulators, surge protectors, power alarm detection circuitry and one or more backup power sources such as a battery or capacitor. Power alarm detection circuitry may detect one or more of brown out (under-voltage) and surge (over-voltage) conditions.

In some aspects, power tee circuitry 1430 may provide for electrical power drawn from a network cable to provide both power supply and data connectivity to the base station radio head 1400 using a single cable.

In some aspects, network controller 1435 may provide connectivity to a network using a standard network interface protocol such as Ethernet. Network connectivity may be provided using a physical connection which is one of electrical (commonly referred to as copper interconnect), optical or wireless.

In some aspects, satellite navigation receiver module 1445 may include circuitry to receive and decode signals transmitted by one or more navigation satellite constellations such as the global positioning system (GPS), Globalnaya Navigatsionnaya Sputnikovaya Sistema (GLONASS), Galileo and/or BeiDou. The receiver 1445 may provide data to application processor 1405 which may include one or more of position data or time data. Application processor 1405 may use time data to synchronize operations with other radio base stations.

In some aspects, user interface 1450 may include one or more of physical or virtual buttons, such as a reset button, one or more indicators such as light emitting diodes (LEDs) and a display screen.

Another example is a computer program having a program code for performing at least one of the methods described herein, when the computer program is executed on a computer, a processor, or a programmable hardware component. Another example is a machine-readable storage including machine readable instructions, when executed, to implement a method or realize an apparatus as described herein. A further example is a machine-readable medium including code, when executed, to cause a machine to perform any of the methods described herein.

The examples as described herein may be summarized as follows:

An example (e.g., example 1) relates to a DAC. The DAC includes a main DAC including a plurality of DAC cells and a TDC. The main DAC is configured to generate an analog output signal based on digital input data. The TDC is coupled to an output of the main DAC and configured to measure a timing error of the main DAC.

Another example, (e.g., example 2) relates to a previously described example (e.g., example 1), wherein a reference signal is provided to the TDC and the TDC is configured to measure the timing error based on the reference signal.

Another example, (e.g., example 3) relates to a previously described example (e.g., any one of examples 1-2), wherein the reference signal is derived from a clock signal that is fed to the main DAC.

Another example, (e.g., example 4) relates to a previously described example (e.g., any one of examples 2-3), wherein the reference signal is an output of a reference DAC cell.

Another example, (e.g., example 5) relates to a previously described example (e.g., example 4), wherein the reference DAC cell is one of the plurality of DAC cells of the main DAC.

Another example, (e.g., example 6) relates to a previously described example (e.g., any one of examples 2-5), further comprising an adjustable delay unit configured to delay either the reference signal or the analog output signal from the main DAC in front of the TDC.

Another example, (e.g., example 7) relates to a previously described example (e.g., any one of examples 2-6), further comprising a gain unit configured to adjust a signal amplitude of either the reference signal or the analog output signal from the main DAC.

Another example, (e.g., example 8) relates to a previously described example (e.g., any one of examples 1-7), wherein the main DAC is a segmented DAC, and the timing error is measured for each segment of the segmented DAC, or the main DAC is a time-interleaved DAC including a plurality of sub-DACs and the timing error is measured for each sub-DAC.

Another example, (e.g., example 9) relates to a previously described example (e.g., any one of examples 1-8), further comprising a post processing block to process the timing error measured by the TDC.

Another example, (e.g., example 10) relates to a previously described example (e.g., any one of examples 1-9), further comprising a cell skew error determination circuit configured to determine skew errors of the DAC cells based on the timing error determined by the TDC, a correction DAC configured to generate a correction signal based on the skew errors, and a combiner configured to combine the correction signal with the analog output signal of the main DAC.

Another example, (e.g., example 11) relates to a previously described example (e.g., any one of examples 1-10), further comprising a skew correction unit configured to adjust the digital input data based on the timing error of the main DAC.

Another example, (e.g., example 12) relates to a previously described example (e.g., any one of examples 1-11), further comprising a skew correction unit configured to trim a timing of each DAC cell based on the timing error of each DAC cell.

An example (e.g., example 13) relates to a method for measuring and correcting timing errors of a DAC. The method includes generating, using a DAC including a plurality of DAC cells, an analog output signal based on digital input data, and measuring, using a TDC coupled to an output of the DAC, a timing error of the DAC.

Another example, (e.g., example 14) relates to a previously described example (e.g., example 13), wherein a reference signal is provided to the TDC, and the timing error is measured based on the reference signal.

Another example, (e.g., example 15) relates to a previously described example (e.g., example 14), wherein the reference signal is derived from a clock signal that is fed to the DAC.

Another example, (e.g., example 16) relates to a previously described example (e.g., any one of examples 14-15), wherein the reference signal is provided by a reference DAC cell.

Another example, (e.g., example 17) relates to a previously described example (e.g., any one of examples 14-16), further comprising applying a delay either on the reference signal or the analog output signal of the DAC in front of the TDC.

Another example, (e.g., example 18) relates to a previously described example (e.g., any one of examples 13-17), further comprising performing post-processing on the timing error measured by the TDC.

Another example, (e.g., example 19) relates to a previously described example (e.g., any one of examples 13-18), further comprising determining skew errors of the DAC cells based on the timing error determined by the TDC, generating a correction signal based on the skew errors, and combining the correction signal with the analog output signal of the DAC.

Another example, (e.g., example 20) relates to a previously described example (e.g., any one of examples 13-19), further comprising adjusting the digital input data based on the timing error of the main DAC, or trimming a timing of each DAC cell based on the timing error of each DAC cell.

The aspects and features mentioned and described together with one or more of the previously detailed examples and figures, may as well be combined with one or more of the other examples in order to replace a like feature of the other example or in order to additionally introduce the feature to the other example.

Examples may further be or relate to a computer program having a program code for performing one or more of the above methods, when the computer program is executed on a computer or processor. Steps, operations or processes of various above-described methods may be performed by programmed computers or processors. Examples may also cover program storage devices such as digital data storage media, which are machine, processor or computer readable and encode machine-executable, processor-executable or computer-executable programs of instructions. The instructions perform or cause performing some or all of the acts of the above-described methods. The program storage devices may comprise or be, for instance, digital memories, magnetic storage media such as magnetic disks and magnetic tapes, hard drives, or optically readable digital data storage media. Further examples may also cover computers, processors or control units programmed to perform the acts of the above-described methods or (field) programmable logic arrays ((F) PLAs) or (field) programmable gate arrays ((F)PGAs), programmed to perform the acts of the above-described methods.

The description and drawings merely illustrate the principles of the disclosure. Furthermore, all examples recited herein are principally intended expressly to be only for pedagogical purposes to aid the reader in understanding the principles of the disclosure and the concepts contributed by the inventor(s) to furthering the art. All statements herein reciting principles, aspects, and examples of the disclosure, as well as specific examples thereof, are intended to encompass equivalents thereof.

A functional block denoted as "means for ..." performing a certain function may refer to a circuit that is configured to perform a certain function. Hence, a "means for s.th." may be implemented as a "means configured to or suited for s.th.", such as a device or a circuit configured to or suited for the respective task.

Functions of various elements shown in the figures, including any functional blocks labeled as "means", "means for providing a sensor signal", "means for generating a transmit signal.", etc., may be implemented in the form of dedicated hardware, such as "a signal provider", "a signal processing unit", "a processor", "a controller", etc. as well as hardware capable of executing software in association with appropriate software. When provided by a processor, the functions may be provided by a single dedicated processor, by a single shared processor, or by a plurality of individual processors, some of which or all of which may be shared. However, the term "processor" or "controller" is by far not limited to hardware exclusively capable of executing software but may include digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

A block diagram may, for instance, illustrate a high-level circuit diagram implementing the principles of the disclosure. Similarly, a flow chart, a flow diagram, a state transition diagram, a pseudo code, and the like may represent various processes, operations or steps, which may, for instance, be substantially represented in computer readable medium and so executed by a computer or processor, whether or not such computer or processor is explicitly shown. Methods disclosed in the specification or in the claims may be implemented by a device having means for performing each of the respective acts of these methods.

It is to be understood that the disclosure of multiple acts, processes, operations, steps or functions disclosed in the specification or claims may not be construed as to be within the specific order, unless explicitly or implicitly stated otherwise, for instance for technical reasons. Therefore, the disclosure of multiple acts or functions will not limit these to a particular order unless such acts or functions are not interchangeable for technical reasons. Furthermore, in some examples a single act, function, process, operation or step may include or may be broken into multiple sub-acts, -functions, -processes, -operations or -steps, respectively. Such sub acts may be included and part of the disclosure of this single act unless explicitly excluded.

Furthermore, the following claims are hereby incorporated into the detailed description, where each claim may stand on its own as a separate example. While each claim may stand on its own as a separate example, it is to be noted that - although a dependent claim may refer in the claims to a specific combination with one or more other claims - other examples may also include a combination of the dependent claim with the subject matter of each other dependent or independent claim. Such combinations are explicitly proposed herein unless it is stated that a specific combination is not intended. Furthermore, it is intended to include also features of a claim to any other independent claim even if this claim is not directly made dependent to the independent claim.

**Claims**

1. A digital-to-analog converter, DAC, comprising:

   a main DAC (410, 610, 710, 810, 910, 1010) including a plurality of DAC cells, wherein the main DAC (410, 610, 710, 810, 910, 1010) is configured to generate an analog output signal based on digital input data; and

a time-to-digital converter, TDC, (420, 620, 720, 820, 920, 1020) coupled to an output of the main DAC (410, 610, 710, 810, 910, 1010) and configured to measure a timing error of the main DAC (410, 610, 710, 810, 910, 1010).

2. The DAC of claim 1, wherein a reference signal is provided to the TDC (420, 620, 720, 820, 920, 1020) and the TDC (420, 620, 720, 820, 920, 1020) is configured to measure the timing error based on the reference signal.

3. The DAC of claim 2, wherein the reference signal is derived from a clock signal that is fed to the main DAC (410, 610, 710, 810, 910, 1010) or an output of a reference DAC cell.

4. The DAC as in any one of claims 2-3, further comprising:
an adjustable delay unit configured to delay either the reference signal or the analog output signal from the main DAC (410, 610, 710, 810, 910, 1010) in front of the TDC (420, 620, 720, 820, 920, 1020).

5. The DAC as in any one of claims 2-4, further comprising:
a gain unit configured to adjust a signal amplitude of either the reference signal or the analog output signal from the main DAC (410, 610, 710, 810, 910, 1010).

6. The DAC as in any one of claims 1-5, wherein the main DAC is a segmented DAC, and the timing error is measured for each segment of the segmented DAC, or the main DAC is a time-interleaved DAC including a plurality of sub-DACs and the timing error is measured for each sub-DAC.

7. The DAC as in any one of claims 1-6, further comprising:

a cell skew error determination circuit (640) configured to determine skew errors of the DAC cells based on the timing error determined by the TDC (420, 620, 720, 820, 920, 1020);
a correction DAC (650) configured to generate a correction signal based on the skew errors; and
a combiner (614) configured to combine the correction signal with the analog output signal of the main DAC (410, 610, 710, 810, 910, 1010).

8. The DAC as in any one of claims 1-7, further comprising:
a skew correction unit (660) configured to adjust the digital input data based on the timing error of the main DAC.

9. The DAC as in any one of claims 1-8, further comprising:
a skew correction unit (670) configured to trim a timing of each DAC cell based on the timing error of each DAC cell.

10. A method for measuring and correcting timing errors of a digital-to-analog converter, DAC, comprising:

generating, using a DAC (410, 610, 710, 810, 910, 1010) including a plurality of DAC cells, an analog output signal based on digital input data; and
measuring, using a time-to-digital converter, TDC, (420, 620, 720, 820, 920, 1020) coupled to an output of the DAC (410, 610, 710, 810, 910, 1010), a timing error of the DAC (410, 610, 710, 810, 910, 1010).

11. The method of claim 10, wherein a reference signal is provided to the TDC (420, 620, 720, 820, 920, 1020), and the timing error is measured based on the reference signal.

12. The method of claim 11, wherein the reference signal is derived from a clock signal that is fed to the DAC (410, 610, 710, 810, 910, 1010) or a signal provided by a reference DAC cell.

13. The method as in any one of claims 11-12, further comprising:
applying a delay either on the reference signal or the analog output signal of the DAC (410, 610, 710, 810, 910, 1010) in front of the TDC (420, 620, 720, 820, 920, 1020).

14. The method as in any one of claims 10-13, further comprising:

determining skew errors of the DAC cells based on the timing error determined by the TDC (420, 620, 720, 820, 920, 1020);
generating a correction signal based on the skew errors; and
combining the correction signal with the analog output signal of the DAC (410, 610, 710, 810, 910, 1010).

**15.** The method as in any one of claims 10-14, further comprising:
adjusting the digital input data based on the timing error of the DAC (410, 610, 710, 810, 910, 1010), or trimming a timing of each DAC cell based on the timing error of each DAC cell.

FIG. 1

FIG. 2

FIG. 3A

FIG. 3B

FIG. 3C

FIG. 4

FIG. 5

FIG. 6A

FIG. 6B

FIG. 6C

710

710a

714 output

data
N bits

$d_{MSB}$
M bits

D/A
MSB

720

$d_{LSB}$
L bits

710b

D/A
LSB

TDC

Skew
error

FIG. 7

810

810a

data1
N bits

D/A

810b

data2
N bits

D/A

⊕

output

820

TDC

Time-interleaved
DAC

Skew
error

FIG. 8

FIG. 9

FIG. 10

010101...

Reference
Cell — 1016

1022

data
N bits

$d_0$ — Cell 0 — 1010

$d_1$ — Cell 1

$d_2$ — Cell 2

⋮

$d_M$ — Cell M

⊕ — 1018

output

1042 — Gain and/or
Delay — 1044

D

1020
M
parallel
registers

Q

M
bits

DAC with individual
cells

Post-
processing
(optional)

Skew
error

FIG. 11

An analog output signal is generated based on digital input data using a
DAC including a plurality of DAC cells.
(1202)

A timing error of the DAC is then measured using a TDC coupled to an
output of the DAC.
(1204)

FIG. 12

FIG. 13

FIG. 14

Europäisches
Patentamt

European
Patent Office

Office européen
des brevets

# EUROPEAN SEARCH REPORT

Application Number

EP 24 21 7394

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 105 322 965 A (INST OF MICROELECTRONICS CAS) 10 February 2016 (2016-02-10)<br>* paragraphs [0019], [0061]; figures 1-3 * | 1-15 | INV.<br>H03M1/10<br><br>ADD.<br>H03M1/74 |
| X | CN 102 769 470 A (UNIV ZHEJIANG) 7 November 2012 (2012-11-07)<br>* Abstract;<br>figures 2,6-10 * | 1,10 | |
| X | YONGJIAN TANG ET AL: "DDL-based calibration techniques for timing errors in current-steering DACs",<br>2006 IEEE INTERNATIONAL SYMPOSIUM ON CIRCUITS AND SYSTEMS 21-24 MAY 2006 ISLAND OF KOS, GREECE, IEEE - PISCATAWAY, NJ, USA,<br>21 May 2006 (2006-05-21), page 4pp,<br>XP032457655,<br>DOI: 10.1109/ISCAS.2006.1692532<br>ISBN: 978-0-7803-9389-9<br>* Section III;<br>figures 1-6 * | 1,6,10 | |
| A | GEIGER R L ET AL: "A 1.5-v 14-bit 100-MS/s self-calibrated DAC",<br>IEEE JOURNAL OF SOLID-STATE CIRCUITS, IEEE, USA,<br>vol. 38, no. 12,<br>1 December 2003 (2003-12-01), pages 2051-2060, XP011104256,<br>ISSN: 0018-9200, DOI:<br>10.1109/JSSC.2003.819163<br>* figure 1 * | 1-15 | TECHNICAL FIELDS SEARCHED (IPC)<br><br>H03M |

The present search report has been drawn up for all claims

| Place of search | Date of completion of the search | Examiner |
|---|---|---|
| The Hague | 31 March 2025 | Jesus, Paulo |

EPO FORM 1503 03.82 (P04C01)

## ANNEX TO THE EUROPEAN SEARCH REPORT
## ON EUROPEAN PATENT APPLICATION NO.

EP 24 21 7394

This annex lists the patent family members relating to the patent documents cited in the above-mentioned European search report.
The members are as contained in the European Patent Office EDP file on
The European Patent Office is in no way liable for these particulars which are merely given for the purpose of information.

31-03-2025

| Patent document cited in search report | | Publication date | Patent family member(s) | Publication date |
|---|---|---|---|---|
| CN 105322965 | A | 10-02-2016 | NONE | |
| CN 102769470 | A | 07-11-2012 | NONE | |

EPO FORM P0459

For more details about this annex : see Official Journal of the European Patent Office, No. 12/82